# EUROPEAN PATENT APPLICATION

(11) **EP 3 656 466 A1**
(43) Date of publication of application: **27.05.2020**
(21) Application number: 18207702.4
(22) Date of filing: 22.11.2018
(51) Int. Cl.: B01J 19/08, C10G 32/00, C10G 32/02, C02F 1/48

(54) **METHOD OF LIQUID PROCESSING BY ALTERNATING ELECTROMAGNETIC FIELD**

(71) Applicant: Kukushkin, Vladimir Yurievich, Yaroslavskaya obl. 152101 (RU)
(72) Inventor: Kukushkin, Vladimir Yurievich, Yaroslavskaya obl. 152101 (RU)
(74) Representative: Kromanis, Artis

(57) **Abstract**

The invention relates to the alternating electromagnetic field treatment of liquid, especially hydrocarbon fuels, water and water solutions, alcohol solutions, wine, wine materials, biological liquids and other materials under certain conditions in the liquid state.

A method for liquid processing by an alternating electromagnetic field, characterized in that the alternating electromagnetic field is generated by applying unipolar DC pulses generated by a pulse generator (A1) to a parallel oscillator circuit (A2) connected thereto, wherein the parallel oscillator circuit (A2) comprises a parallel-connected inductance (L) and capacitance (C5), in result of which an inductance (L) of the parallel oscillator circuit (A2) upon receipt of unipolar DC pulses generated by a pulse generator (A1) generates the alternating electromagnetic field used for processing of liquid.

## Description

### Field of the invention

The invention relates to the alternating electromagnetic field treatment of liquid, especially hydrocarbon fuels, water and water solutions, alcohol solutions, wine, wine materials, biological liquids and other materials under certain conditions in the liquid state. The invention can be used in industry, power system, utilities, agricultural area, medicine, housekeeping, transport and other fields requiring treatment of fluids.

### Background

Russian patent publication No. RU 2546886 discloses a device for magnetoacoustic treatment of liquid hydrocarbon fuel, containing the housing, inlet and outlet fuel nozzles, AC inductor, and also an internal cylindrical chamber from non-conducting material for fuel passing connected with inlet and outlet nozzles is offered. Inside the chamber coaxially with it a thin-walled metal tube is installed, and at distances from the ends of the metal tube the permanent magnets designed as disks and facing to each other with unlike poles are located. This device uses the alternating electrical current generating the alternating electromagnetic fields in the inductor; the alternating electric field has a frequency of the supply current.

Russian patent publication No. RU 2524718 discloses a device for electromagnetic treatment of water and fluids. The device comprises inductors arranged around pipeline and made of diamagnetic material and connected to electromagnetic pulse generators. Every inductor is composed of turns of electrically isolated wire. Electronic control unit comprises two galvanically isolated four-channel electromagnetic pulse generators to generate forward and reverse signals. One end of wire of every inductor is connected to one output of every said generator. Second end of wire of every inductor is connected to appropriate outlet of another generator of electromagnetic pulses. In this device, the inducers are connected to the DC pulse generators producing alternating electromagnetic field. The generators generate direct and inverted signals changing the DC polarity at the inducers outputs.

### Summary of invention

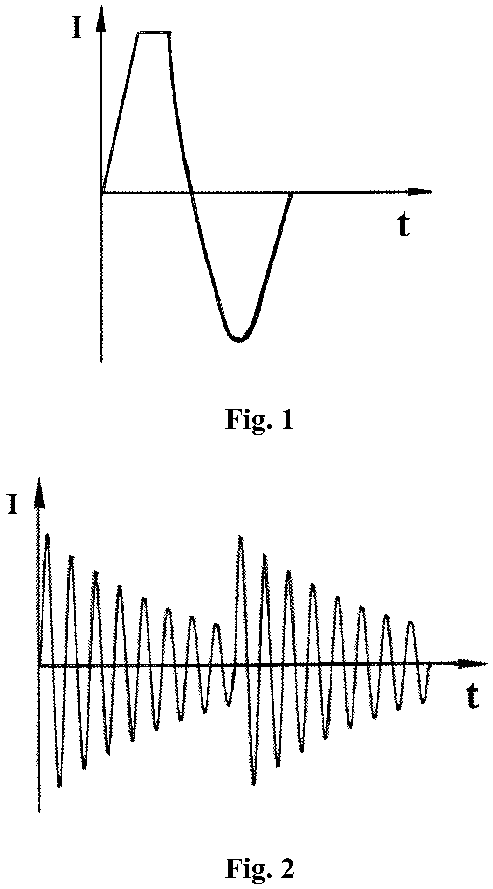

The technical invention is intended for processing of liquid with an alternating electromagnetic field in order to change physical properties and improve consumer quality of the liquid. The technical solution of the present invention is an appliance of a device, that comprises a DC pulses generator (A1) and a parallel oscillating circuit (A2) connected thereto, the inductance (L) of the later, when a parallel oscillating circuit is exposed to pulse generator (A1) DC pulses, emits the alternating magnetic field that is used for processing of the liquid. After the exposure of single DC pulse on the parallel oscillating circuit, with a duration that is enough for energy accumulation in the inductance of the parallel oscillating circuit, a reactive power that circulates within the parallel oscillating circuit occurs: in one part of the period the inductance magnetic field energy becomes the capacity electric field energy and vice versa in the second part of the period. At low self-frequencies of the parallel oscillating circuit or in case of inequality of reactance components of its inductance and capacitance, when the DC pulse is applied, the parallel oscillating circuit generates a single alternating electromagnetic pulse (Fig. 1) that is emitted by inductance of the parallel oscillating circuit. The magnitude of the positive and negative half-waves of the alternating electromagnetic pulse depends on the magnitude of the reactance of inductance and capacitance of the oscillating circuit. In order to generate the alternating electromagnetic field, a sequence of alternating electromagnetic pulses that occurs on exposure of the parallel oscillating circuit (A2) to DC pulses, that are produced by the DC pulse generator (A1), with a frequency in the range of 0.1-1000 Hz and pulse duration in the range of 50 µs - 5 ms. If the values of parallel oscillating circuit (A2) self-oscillation are in the range of 50 kHz - 10 MHz, the alternating electromagnetic field is obtained by exposure of the parallel oscillating circuit (A2) to pulse generator (A1) DC pulses with a frequency of 10 - 250 kHz and duration of 50 ns - 50 µs. As a result, the self-oscillation occurs in the parallel oscillating circuit (A2). Due to internal resistance of the parallel oscillating circuit (A2), the oscillation amplitude decreases with each period. Then the pulse generator (A1) generates the next DC pulse and the process repeats (Fig.2) once again. Due to self-oscillation in the parallel oscillating circuit (A2), the emission of the alternating electromagnetic field, between the exposure of the parallel oscillating circuit to pulse generator (A1) unipolar DC pulses, occurs without the external energy. The pulse generator (A1) frequency does not depend on the self-oscillation frequency in the parallel oscillating circuit (A2). For the highest liquid processing efficiency, the frequency is chosen so that the next pulse generator (A1) DC pulse exposes on the parallel oscillating circuit (A2) till the end of the damping self-oscillation process.

In order to directly expose the liquid to the alternating magnetic field, the inductance (L) of the parallel oscillating circuit is immersed in the medium. The inductance (L), capacitance (C5) of the parallel oscillating circuit (A2) and the pulse generator (A1) are connected in a single circuit. If the immersion in a liquid is impossible, the inductance (L) of the parallel oscillating circuit is arranged directly on the outer walls of pipelines and tanks made of dielectric materials as close as possible to the liquid medium being processed. The inductance (L), capacitance (C5) of the parallel oscillating circuit (A2) and the pulse generator (A1) are arranged in a single or multiple housings and connected in a circuit.

The several parallel-connected inductances (L) of the parallel oscillating circuit (A2) connected via electric circuit to the capacitance (C5) of the parallel oscillating circuit and the pulse generator (A1) are used in order to increase the processing area of the liquid medium with the alternating magnetic field. Furthermore, the inductances of the parallel oscillating circuit are uniformly arranged in liquid or on the walls of the pipelines, tanks made of dielectric materials.

The claimed invention differs from the prior art in terms of appliance of the device that is capable of emitting alternating magnetic field obtainable as a result of exposure of the oscillating circuit (A2) to pulse generator (A1) DC pulses.

The appliance of the proposed method results in that the liquid shows an enhanced fluidity. The conclusion about the enhanced fluidity of water processed according to the claimed method is based on the results of carried out experiment. Two identical samples of the cement-bonded sand were used for the concrete manufacturing. The unprocessed water and water processed by the claimed method was added to the first and second mix accordingly. The amount of processed water that is necessary to obtain the concrete samples of same viscosity is 15% less. The conclusion about the enhanced fluidity of the petrol is based on the results of the experiment with the gasoline vehicle. The initial vehicle engine power characteristics were recorded by chassis dynamometer system. The petrol was processed by means of the device, that is used in the claimed method, engaged to the vehicle engine fuel supply hose. After 1000 km logged the control characteristics were recorded by the chassis dynamometer system. At the engine rpm speed in the range of 1500 - 2500 rpm the 15-20% power ascension about initial characteristics was detected. At the engine rpm speed in the range of 2500 - 5000 rpm the 8-10% power ascension about initial characteristics was detected. Based on the results, it was concluded, that after the processing via the claimed method the petrol gained the enhanced fluidity, much better dissipates and combusts more completely in a compression chamber therefore enhancing the horsepower of the internal combustion engine.

### Brief description of the drawings

Fig. **1** - illustrates an alternating electromagnetic pulse generated by a parallel oscillator circuit after a DC pulse application.
Fig. **2** - illustrates a self-oscillation process in a parallel resonant circuit when subjected to a DC unipolar pulses.
Fig. **3** - illustrates a scheme of a parallel oscillator circuit **A2**, a pulse generator **A1** and electrical connections.

### Detailed description of certain embodiments

A method for liquid processing by an alternating electromagnetic field is performed by a pulse generator **A1** connected to a parallel oscillator circuit **A2**. The parallel oscillator circuit **A2** comprises a capacitance **C5** and an inductance **L**. In one embodiment the pulse generator **A1** comprises a controller **D1** type NE555. NE555 is an Integrated Circuit (IC/Chip) which can be used in different types of timers. The pulse generator **A1** further comprises capacitances **C1** - 2200µF x 25v; **C2** - 0,1µF; **C3** - 0,1µF; **C4** - 0,1µF; and **C5** - 4,7µF and resistances **R1** - 57kΩ and **R2** - 1,5kΩ. The pulse generator **A1** further comprises MOSFET **Q1** - IRF3205.

The pulse generator **A1** is any known unipolar DC pulse generator with low output resistance. The parallel oscillating circuit **A2** is produced from parallel-connected condenser **C5** and inductance coil **L** made of insulated wire. If the increase of the inductance value is required, an inductance **L** core is used. In this case, the alternating electromagnetic field used for processing of the liquid is emitted from the poles of the core. At low natural frequency of the parallel oscillating circuit **A2**, a core is produced from low-coercivity materials such as iron.

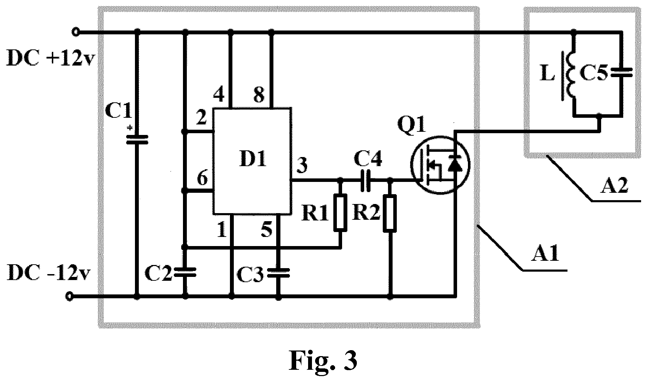

At high natural frequency of the parallel oscillating circuit **A2**, a core is produced from ferrite materials. The parallel oscillating circuit **A2** and pulse generator **A1** are connected via electric circuit (Fig. **3**). The pulse generator **A1** is powered from an external power source.

In one of the embodiments, the pulse generator **A1** is designed on timer NE555. 100 Hz frequency is used, adjusted by means of **C2-R1**. The duration of DC pulses used is 0.12 ms, adjusted by means of **C4-R2**. **C1** - polar capacitor that accumulates energy between the DC pulses. The MOSFET - transistor **Q1** with low resistance in the open position - is used. The inductance **L** is spooled on the iron core (d=8 mm, 1=30 mm) that is isolated with a copper wire (d=0.5 mm). All members are connected according to the scheme (Fig. 3). DC peripheral power supply 12v is used for the pulse generator **A1**. For the processing of the liquid the alternating electromagnetic field emitted by one of the inductance **L** poles is applied.

## Claims

1. A method for liquid processing by an alternating electromagnetic field, **characterized in that** the alternating electromagnetic field is generated by applying unipolar DC pulses generated by a pulse generator (A1) to a parallel oscillator circuit (A2) connected thereto, wherein the parallel oscillator circuit (A2) comprises a parallel-connected inductance (L) and capacitance (C5), in result of which an inductance (L) of the parallel oscillator circuit (A2) upon receipt of unipolar DC pulses generated by a pulse generator (A1) generates the alternating electromagnetic field used for processing of liquid.

2. The method according to Claim 1, **characterized in that** the pulse generator (A1) generates the pulses in a range of 0.1 to 1000 Hz and duration of the pulse is in range of 50 µs to 5 ms.

3. The method according to Claim 1, **characterized in that** the pulse generator (A1) generates the pulses in a range of 10 to 250 kHz and duration of the pulse is in range of 50 ns to 50 µs.

4. The method according to any of Claims 1 to 3, **characterized in that** in order to increase the processing area of the liquid, several parallel-connected inductances (L) of the parallel oscillator circuit (A2) are connected to each other and to the capacitance (C5) of the parallel oscillator circuit (A2) and to the pulse generator (A1).
